(19) Europäisches Patentamt
European Patent Office
Office européen des brevets

(11) **EP 2 011 765 A1**

(12) **EUROPEAN PATENT APPLICATION**
published in accordance with Art. 153(4) EPC

(43) Date of publication:
**07.01.2009 Bulletin 2009/02**

(51) Int Cl.:
*C01F 17/00* (2006.01)          *B24B 37/00* (2006.01)
*C09K 3/14* (2006.01)          *H01L 21/304* (2006.01)

(21) Application number: **07742560.1**

(22) Date of filing: **26.04.2007**

(86) International application number:
**PCT/JP2007/059125**

(87) International publication number:
**WO 2007/126030 (08.11.2007 Gazette 2007/45)**

(84) Designated Contracting States:
**AT BE BG CH CY CZ DE DK EE ES FI FR GB GR
HU IE IS IT LI LT LU LV MC MT NL PL PT RO SE
SI SK TR**
Designated Extension States:
**AL BA HR MK RS**

(30) Priority: **27.04.2006 JP 2006123828**

(71) Applicant: **Asahi Glass Company, Limited
Chiyoda-ku
Tokyo 100-8405 (JP)**

(72) Inventors:
• **SAKAI, Tomohiro**
  **Chiyoda-ku, Tokyo 100-8405 (JP)**
• **BEPPU, Yoshihisa**
  **Chiyoda-ku, Tokyo 100-8405 (JP)**
• **SUNAHARA, Kazuo**
  **Chiyoda-ku, Tokyo 100-8405 (JP)**

(74) Representative: **Perrey, Ralf
Müller-Boré & Partner,
Grafinger Strasse 2
81671 München (DE)**

(54) **OXIDE CRYSTAL FINE PARTICLE AND POLISHING SLURRY INCLUDING THE FINE PARTICLE**

(57)     To provide a slurry for polishing which is excellent in polishing properties, can suppress scratches and is appropriate for accurate polishing in semiconductor production steps, and fine particles of oxide crystal for it.

Fine particles of oxide crystal, **characterized in that** the ratio of the crystallite size measured by X-ray diffraction method and calculated by Scherrer method to the average primary particle size equivalent to sphere from the specific surface area measured by BET is the crystallite size:the average primary particle size = 1:0.8 to 1: 2.5. A slurry for polishing, **characterized in that** the fine particles of oxide crystal are dispersed in a liquid medium, and from 0.1 to 40 mass% of the fine particles of oxide crystal are contained, per the total mass of the slurry for polishing.

Fig. 1

50nm

EP 2 011 765 A1

**Description**

TECHNICAL FIELD

The present invention relates to fine particles of oxide crystal and a slurry for polishing which contains the fine particles.

BACKGROUND ART

Recently, along with the progress in the integration and functionality of semiconductor integrated circuits, there has been a demand for development of microfabrication techniques for miniaturization and densification. Planarization techniques for interlayer insulating films and embedded wirings are important in semiconductor device production processes, in particular, in a process of forming multilayered wirings. That is, as wirings are increasingly multilayered due to the miniaturization and densification in the semiconductor production processes, the degree of roughness tends to increase in the surfaces of the individual layers, resulting in a situation where the difference in level exceeds the depth of focus in lithography. In order to avoid such a problem, high planarization techniques are important in the process of forming multilayered wirings.

As the material for such wirings, copper has attracted attention because of its low resistivity as compared with conventional aluminum alloys and also because of its excellence in electromigration resistance. Since the vapor pressure of copper chloride gas is low, it is difficult to form copper into the shape of wirings by Reactive Ion Etching (RIE) which has been commonly used. Therefore, in order to form the wirings, a Damascene method is used. This is a method such that concave portions such as trench patterns for wirings and via holes, are formed in an insulating layer. A barrier layer is then formed thereon, and then copper is deposited by sputtering, plating or the like so as to be embedded in the trench portions. Then, excess copper and barrier layer are removed by Chemical Mechanical Polishing method (Chemical Mechanical Polishing, hereinafter referred to as "CMP") until the surface of the insulating layer is exposed, other than the portions corresponding to the concave portions, whereby the surface is planarized, and embedded metal wirings are formed.

Multilayered wirings are formed by depositing a $SiO_2$ film as an interlayer insulating film on embedded wirings, planarizing the $SiO_2$ film by CMP and forming next embedded wirings. Recently, a Dual Damascene method (Dual Damascene) has been predominantly used, in which copper wirings having copper embedded in concave portions and via holes are simultaneously formed (for example, Patent Document 1).

In the formation of such embedded copper wirings, tantalum, a tantalum alloy, tantalum nitride or the like is formed as a barrier layer in order to prevent Cu from diffusing to the insulating film. Accordingly, other than the wiring portions at which Cu is embedded, it is necessary to remove an exposed barrier layer by CMP. Further, in order to electrically isolate among devices such as transistors etc., Shallow Trench Isolation (hereinafter referred to as STI) is employed. STI is a method wherein while a device region is masked with a SiN film, a trench is formed on a silicon substrate, a $SiO_2$ film is then deposited as an insulating layer so as to fill the trench, and an excess $SiO_2$ film on the SiN film is removed by CMP, whereby the device region is electrically isolated. In the formation of such embedded Cu wirings, a wafer surface to be planarized is naturally a surface on which devices are to be formed, and therefore processing defects must be substantially prevented in a polishing step. One of the most serious problems of the processing defects is scratch. For example, scratch is known as a factor to deteriorate yield, because even though the size of scratch is within the range equivalent to e.g. a design rule for the device, W, Cu or the like remains in a concave which is the inside of the scratch in a CMP process for metals (for example, Non Patent Document 1). Therefore, it is necessary to reduce scratches remaining after polishing.

Heretofore, as an abrasive for semiconductor CMP, a slurry (hereinafter sometimes referred to as a slurry for polishing) has been used wherein fine particles of an oxide such as cerium oxide or aluminum oxide as abrasive grains are dispersed in water or an aqueous medium, and an additive such as a pH adjuster or a dispersing agent is added thereto.

It is considered that scratches are formed basically by large particles having an excessively large particle size. Accordingly, as a countermeasure, a method to reduce including of such large particles in the slurry for polishing has been studied. For example, Patent Document 2 proposes a method which can suppress scratch, while maintaining a high polishing property, by using cerium oxide particles which have a polycrystalline shape formed from at least two crystallites, and which can develop an active surface contributing to polishing, while the polycrystalline shape collapses at the time of polishing. However, in a case where such particles are used as abrasive grains, the problem of fine scratches, which are supposed to be formed due to the existence of coarse particles, is not still solved. In recent years, along with the progress in the integration and functionality of semiconductor devices, for example, formation of scratches which are larger than 0.2 $\mu$m on a 8 inch wafer is required to be reduced to at most 1,500, more preferably at most 1,000, and the invention of a slurry for polishing, which can highly effectively suppress the formation of fine scratches is demanded urgently.

Patent Document 1: JP-A-2004-55861 (Claims)
Patent Document 2: JP 3727241 (Claims)
Non-Patent Document 1: Detailed Explanation, Semiconductor CMP Techniques, Toshiro Doi, Kogyo Chosakai Publishing, Inc., P321 (2000)

DISCLOSURE OF THE INVENTION

OBJECT TO BE ACCOMPLISHED BY THE INVENTION

The present invention relates to fine particles of oxide crystal having a single crystal structure and a slurry for polishing which contains the fine particles, and particularly it is an object of the present invention to provide a slurry for polishing which can suppress the formation of fine scratches on a surface to be polished in semiconductor device production processes and is appropriate to precision polishing.

MEANS TO ACCOMPLISH THE OBJECT

In order to accomplish the above object, the present inventors have extensively studied the relationship between the crystal structure of abrasive grains and the formation of scratches, and as a result, it has been found possible to suppress the formation of fine scratches by using fine particles of oxide crystal which are single crystal, wherein the ratio of the crystallite size measured by X-ray diffraction method and calculated by Scherrer method to the average primary particle size equivalent to sphere from the specific surface area measured by BET is controlled within a specific range. The present invention has been accomplished based on the above discovery and is characterized by having the following constructions.

(1) Fine particles of oxide crystal, characterized in that the ratio of the crystallite size measured by X-ray diffraction method and calculated by Scherrer method to the average primary particle size equivalent to sphere from the specific surface area measured by BET is the crystallite size:the average primary particle size = 1:0.8 to 1:2.5.
(2) The fine particles of oxide crystal according to the above (1), wherein the oxide is at least one selected from the group consisting of ceria, titania, tin oxide, zinc oxide, alumina, manganese oxide, zirconia, germanium oxide and solid solutions thereof.
(3) The fine particles of oxide crystal according to the above (1) or (2), wherein the oxide is ceria.
(4) The fine particles of oxide crystal according to any one of the above (1) to (3), wherein the average primary particle size of the fine particles of oxide crystal is from 5 to 200 nm.
(5) The fine particles of oxide crystal according to any one of the above (1) to (4), wherein the porosity of the fine particles of oxide crystal represented by the following formula 1 is from 0.1 to 8%:

$$\text{Porosity} = (1 - \text{true density/theoretical density}) \times 100 \qquad \text{Formula 1,}$$

wherein the true density (g/cm$^3$) is a value measured by a dry type densimeter, and the theoretical density (g/cm$^3$) is a value described in JCPDS (Joint Committee on Powder Diffraction Standards) card number: 34-0394.
(6) A method which comprises producing the fine particles of oxide crystal as defined in any one of the above (1) to (5) by a flux method, a hydrothermal method, a solid phase reaction method, a sol-gel method or a gas phase method.
(7) A slurry for polishing, characterized in that the fine particles of oxide crystal as defined in any one of the above (1) to (5) are dispersed in a liquid medium, and from 0.1 to 40 mass% of the fine particles of oxide crystal are contained, per the total mass of the slurry for polishing.
(8) The slurry for polishing according to the above (7), wherein the liquid medium is water or an aqueous medium containing water as the main component.
(9) The slurry for polishing according to the above (7) or (8), wherein the average dispersive particle size of the fine particles of oxide crystal is from 10 to 300 nm.

EFFECT OF THE INVENTION

According to the present invention, it is possible to provide a slurry which can suppress the formation of scratches on a surface to be polished and is appropriate to precision polishing in the semiconductor device production processes; and fine particles of oxide crystal for such a slurry. Further, the slurry for polishing is effective also as a slurry for precision polishing for optical disks, magnetic disks, substrates for displays or glass substrates for optical lenses.

BRIEF DESCRIPTION OF THE DRAWINGS

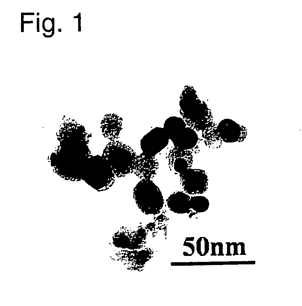

Fig.1 is a transmission electron microscope photograph of $CeO_2$ fine particles obtained in Examples (Example 1) of the present invention.

BEST MODE FOR CARRYING OUT THE INVENTION

Now, the present invention is described in detail.

In general, in a case of polishing with free abrasive grains, the factors for the formation of scratches on a surface to be polished (such as a wafer) may, for example, be a polishing machine, polishing pressure, rotational frequency, concentration of an abrasive slurry, feeding amount, an average particle size and the maximum particle size of abrasive particles, hardness of abrasive particles or types of pad.

As a result of extensive study, the present inventors have found that by controlling the ratio of the crystallite size of fine particles of oxide crystal used as abrasive grains in an abrasive measured by X-ray diffraction method and calculated by Scherrer method (hereinafter referred to as crystallite size) to the average primary particle size of the fine particles equivalent to sphere from the specific surface area measured by BET (hereinafter referred to as average primary particle size), i.e. the crystallite size:the average primary particle size (hereinafter referred to as particle size ratio), to be within the range of from 1:0.8 to 1:2.5, the formation of scratches on a surface to be polished can be highly suppressed, while maintaining a high polishing performance. Thus, the present invention has been accomplished.

Although the reason why scratches can be reduced by employing the above range of the particle size ratio is not necessarily clear, the present inventors consider it as follows. First, by increasing the particle size ratio to at least 1:0.8, the shape of single crystal can be easily maintained, and crystal lattice defects can be reduced, and as a result, active sites which contribute to improve the polishing rate can always be maintained on the outer surface of the abrasive grains. As a result, even if scratches are formed on a surface which exposes in an intermediate step of the polishing processes, such scratches can be disappeared along with the progress of the polishing. On the other hand, by reducing the particle size ratio to at most 1:2.5, the shape of the fine particles of oxide crystal can be easily maintained to the shape of single crystal, and as a result, it is possible to suppress the formation of scratches itself due to inclusion of coarse particles made of polycrystal. The particle size ratio is preferably from 1:1.0 to 1:2.0, more preferably from 1:1.0 to 1:1.8.

The fine particles of oxide crystal are preferably at least one oxide selected from the group consisting of ceria ($CeO_2$), titania ($TiO_2$), tin oxide ($SnO_2$), zinc oxide (no), alumina ($Al_2O_3$), manganese oxide ($MnO_2$), zirconia ($ZrO_2$), germanium oxide (GeO or $GeO_2$) and solid solutions thereof. Particularly, it is preferred that the fine particles of oxide crystal are fine particles made of $CeO_2$, since it is thereby possible to increase the rate of polishing a silicon dioxide material, particularly $SiO_2$, used as a material constituting an interlayer insulating film, and to obtain a surface to be polished which is excellent in flatness.

The average primary particle size of the fine particles of oxide crystal is preferably from 5 to 200 nm. When the average primary particle size is at least 5 nm, the polishing rate can be improved. On the other hand, when the average primary particle size is at most 200 nm, the formation of scratches on a surface to be polished can be suppressed. The average primary particle size is preferably from 10 to 100 nm, more preferably from 10 to 50 nm.

The porosity of the fine particles of oxide crystal is preferably from 0.1 to 8%.

Here, the porosity (%) is a value (%) calculated by the following formula 1 from the ratio of the true density ($g/cm^3$) measured by a dry type densimeter (hereinafter referred to as true density) to the theoretical density ($g/cm^3$) described in JCPDS card number: 34-0394 (hereinafter referred to as theoretical density).

When the porosity is at least 0.1%, active sites which contribute to improving the polishing rate can sufficiently exist on the outer surface of the fine particles of oxide crystal, and as a result, even if scratches are formed on a surface which exposes at an intermediate step of the polishing processes, such scratches can be disappeared along with the progress of the polishing. On the other hand, when the porosity is at most 8%, the fine particles of oxide crystal can be prevented from becoming porous themselves, and the outer surface of the fine particles of oxide crystal can be prevented from being coarse, and as a result, the formation of scratches itself can be suppressed. The porosity is more preferably from 0.1 to 6%, particularly preferably from 3 to 6%.

$$Porosity = (1-true\ density/theoretical\ density) \times 100$$

$$Formula\ 1,$$

The fine particles of oxide crystal can be produced by a known method such as a flux method, a hydrothermal method, a solid phase reaction method, a sol-gel method or a gas phase method.

Among them, the flux method and the solid phase reaction method are particularly preferred, since it is thereby possible to obtain particles having high crystallinity, and to obtain fine particles of oxide crystal having a particle size ratio within a range of from 0.8 to 2.5 and having the shape of single crystal maintained. Among various flux methods, it is preferred to use so-called glass crystallization method wherein oxide particles are crystallized in a glass matrix, followed by removing the glass matrix component, whereby fine crystalline particles having small particle size and single crystal maintained, can be obtained. Namely, it is a method wherein a component to be precipitated as fine particles of oxide crystal is dissolved in a glass matrix melt, the melt is quenched to vitrify, and then heating treatment is carried out again, whereby fine particles of oxide crystal precipitate in the glass matrix. The precipitated fine particles of oxide crystal are taken out by dissolving the glass matrix with a proper agent.

As the glass matrix, a borate type, a phosphate type, a silicate type or the like may be used, and the borate type glass matrix is preferably used from the viewpoints of melting property, easiness of the production of a composite compound containing the desired product, easiness of leaching the glass matrix, etc.

Here, in a case where $CeO_2$ fine particles are produced by the glass crystallization method, a step to obtain a melt containing from 5 to 50% of $CeO_2$, from 10 to 50% of RO (R is at least one selected from the group consisting of Mg, Ca, Sr and Ba) and from 30 to 75% of $B_2O_3$, a step of quenching the melt to obtain an amorphous material, a step of precipitating $CeO_2$ crystal from the amorphous material and a step of separating the $CeO_2$ crystal from the amorphous material are preferably carried out in this order. By employing the above method, it is possible to easily obtain $CeO_2$ fine crystalline particles which are excellent in uniformity of the composition and particle size and have a small particle size.

Here, the step of precipitating $CeO_2$ crystal from the amorphous material is preferably carried out in an atmosphere at a temperature of from 600 to 850°C. By carrying out the crystallization step at a temperature of at least 600°C, $CeO_2$ crystal can be sufficiently precipitated. On the other hand, by carrying out the crystallization step at a temperature of at most 850°C, the particle size ratio can be maintained within the range of 1:0.8 to 1:2.5, and $CeO_2$ fine particles having a single crystal shape can be easily obtained. The crystallization step is more preferably carried out at a temperature of from 650 to 800°C, particularly preferably from 680 to 750°C. Further, the higher the heating temperature is, the larger the crystallite size of crystal to be precipitated is. Therefore, depending on the desired crystallite size, the heating temperature is adjusted.

Then, the fine particles of oxide crystal are dispersed in a proper liquid medium to obtain a slurry for polishing. The liquid medium is not particularly restricted, however, in order to maintain an appropriate viscosity, namely fluidity, of the slurry, water or an aqueous medium containing water as the main component is preferably used. Here, in a case where the desired viscosity cannot be obtained, a viscosity adjustor may be added to the slurry. Further, for the purpose of improving a polishing property or a dispersibility, a solvent which is water-soluble or miscible with water and has a high relative dielectric constant such as methanol, ethanol, propanol, ethylene glycol or propylene glycol may be contained.

The content of the fine particles of oxide crystal in the slurry for polishing is adjusted by taking into consideration the polishing rate, uniform dispersibility and stability at a time of dispersing, and in the present invention, from 0.1 to 40 mass% of the fine particles of oxide crystal is contained in the total mass of the slurry for polishing. If the content is lower than 0.1 mass%, the progress of polishing is insufficient, while if the content exceeds 40 mass%, the viscosity of the slurry is high, it is difficult to maintain a sufficient dispersibility, and it is difficult to handle the slurry for polishing. The content is more preferably from 0.5 to 20 mass%, particularly preferably from 0.5 to 10 mass%.

The fine particles of oxide crystal may be used, as they are, for a slurry for polishing. However, it is preferred to pulverize the fine particles of oxide crystal in a powder state or more preferably wetpulverize them in a suspension having water or a water medium added thereto, followed by dispersing them to obtain a slurry. For example, the above pulverization and dispersion are carried out by means of an apparatus such as a dry jet milling wherein powder particles are collided one another at a high velocity, a ball (beads) milling, a planetary milling, a high pressure homogenizer wherein plural fluids are collided or ultrasonic radiation. Further, in order to remove aggregated particles or coarse particles, filtration treatment with a filter or centrifugal separation may be carried out.

Here, the average dispersive particle size of the oxide crystal in the slurry is preferably from 10 to 300 nm, since scratch property is thereby excellent. The average dispersive particle size is the average particle size of aggregated particles in the slurry for polishing, and in this specification, the average dispersive particle size is a particle size (median size) that an integrated amount of intensive distribution of scattered light measured by dynamic light scattering becomes 50% by cumulating. The average dispersive particle size is more preferably from 20 to 200 nm, particularly preferably from 20 to 150 nm.

Further, within the range which does not impair excellent polishing property and scratch property of the slurry for polishing of the present invention, depending on application, a dispersing agent, a pH adjuster, a pH buffer, an oxidant, a reductant, a resin which can be a stabilizer for fine particles, a dishing inhibitor, an elongation inhibitor or the like may be contained in the slurry.

The dispersing agent may, for example, be an ammonium polycarboxylate or ammonium polyacrylate.

The pH adjuster or the pH buffer may, for example, be an inorganic acid such as nitric acid, an organic acid such as succinic acid or citric acid, a quaternary ammonium hydroxide such as an aqueous ammonium or tetramethyl ammonium hydroxide or an alkali metal hydroxide.

Here, from the viewpoints of keeping the dispersibility of the abrasive grain excellent and the polishing rate sufficient and reducing scratches, the pH of the slurry for polishing is preferably controlled within the range of from 2 to 13.

An object to be polished with the slurry for polishing of the present invention may, for example, be the above mentioned STI substrate for separating shallow trench devices.

By using the slurry for polishing of the present invention, it is possible to polish a $SiO_2$ film at a high polishing rate with little remaining scratches. Further, the slurry for polishing of the present invention is effective for planarizing interlayer insulating films and polysilicons.

The $SiO_2$ film may, for example, be so called PE-TEOS film, wherein film formation is carried out by plasma CVD method with tetraethoxysilane as a material or so called HDP film, wherein film formation is carried out by high density plasma CVD method. Further, as a film made of a silicon dioxide material other than the $SiO_2$ film, SiOF film, BPSG (Boron-phospho-silicate) film, PSG (Phospho-Silicate Glass) film or the like may be used.

EXAMPLES

Now, the present invention will be described in further detail with reference to Examples. However, the present invention is by no means restricted to such specific Examples.

(1) PREPARATION OF SLURRY FOR POLISHING

EXAMPLE 1

Cerium oxide ($CeO_2$), $SrCO_3$ and boron oxide ($B_2O_3$) were weighed so as to be 25.0%, 25.0% and 50.0% respectively, represented by mol% based on $CeO_2$, SrO and $B_2O_3$, and they were sufficiently wet-mixed by an auto mortar with a small amount of ethanol, followed by drying to obtain a material powder. The obtained material powder was set in a platinum container (containing 10 mass% of rhodium) with a nozzle for melt drop and heated and melted completely at 1,350°C for 2 hours in an electric furnace using molybdenum silicide as a heating element. Then, the nozzle part was heated, and the melt was dropped to a twin roll (roll diameter: 150 mm, rotational speed: 300 rpm, roll surface temperature: 30°C) set under the electric furnace, and a flaky solid was obtained.

The obtained flaky solid was transparent, and as a result of X-ray diffraction, it was confirmed that the flaky solid was amorphous. Crystallization treatment was carried out by heating the flaky solid at 700°C for 32 hours. Then, the flaky solid was added in a 1 mol/L acetic acid solution maintained at 80°C and stirred for 12 hours, followed by centrifugation, washing with water and drying to obtain a white powder.

As a result of identification of a mineral phase of the obtained white powder by a X-ray diffractometer (RINT 2500, manufactured by Rigaku corporation), it was found that the mineral phase was cubic crystal, corresponded to a diffraction peak of known $CeO_2$ (JCPDS card number: 34-0394) and was highly crystalline particles made of $CeO_2$ single phase. Fig. 1 shows a photograph of the $CeO_2$ fine particles obtained in Example 1, taken by a transmission electron microscope (JEM-1230, manufactured by JEOL Ltd.). Further, the crystallite size calculated by Scherrer method from a spread of X-ray diffraction line was 25 nm, the average primary particle size equivalent to sphere from the specific surface area measured by Nitrogen adsorption method (BET) was 27 nm, and the crystallite size:the average primary particle was 1:1.1. Further, the porosity calculated by the following formula 1 from the ratio of the true density measured by a dry type densimeter (ACCPYC 1330, manufactured by Shimadzu Corporation) to the theoretical density described in the above JCPDS card was 4.3%.

$$\text{Porosity= (1-true density/theoretical density)} \times 100$$

Formula 1.

25 g of the above obtained $CeO_2$ fine particles, 225 g of deionized water and 250 g of ammonium polyacrylate were added in a container with a cover and mixed, followed by carrying out dispersing treatment by a ball milling using zirconia ball having a diameter of 0.5 mm for 72 hours. Then, the mixture was diluted with deionized water to obtain dispersion A having a $CeO_2$ concentration of 1 mass%. The average dispersive particle size of the dispersion A was measured by a particle size distribution meter (ELS-8000, manufactured by Otsuka Electronics Co., Ltd.) using dynamic light scattering, and it was 68 nm.

Ammonium polyacrylate having a weight average molecular weight of 5,000 (dispersant) and a pH adjuster (nitric acid) were added to the dispersion A to prepare a slurry for polishing having an ammonium polyacrylate concentration of 0.17 mass% and a pH of 5.0. 20 mL of the obtained slurry for polishing was added in a glass test tube having a diameter of 18 mm and left at rest for 10 days. As a result, a supernatant layer did not appear, and the dispersibility was remarkably excellent.

EXAMPLE 2

Cerium oxide ($CeO_2$), $BaCO_3$ and boron oxide ($B_2O_3$) were weighed so as to be 33.4%, 13.3% and 53.3% respectively, represented by mol% based on $CeO_2$, BaO and $B_2O_3$, and they were sufficiently wet-mixed by an auto mortar with a small amount of ethanol, followed by drying to obtain a material powder. To the obtained material powder, melting, cooling and crystallization treatments were carried out in the same manner as in Example 1. The powder was added in a 1 mol/L acetic acid solution maintained at 80°C and stirred, followed by centrifugation, washing with water and drying in the same manner as in Example 1 to obtain a white powder. The crystallite size of the obtained white powder was 33 nm, the average primary particle size was 43 nm, the crystallite size:the average primary particle size was 1:1.3, and the porosity was 1.2%.

Except for using the above obtained $CeO_2$ fine particles, dispersion B having an average dispersive particle size of 81 nm and a $CeO_2$ concentration of 1 mass% was obtained in the same manner as in Example 1. To the dispersion B, ammonium polyacrylate and a pH adjuster were added in the same manner as in Example 1 to prepare a slurry for polishing having an ammonium polyacrylate concentration of 0.17 mass% and a pH of 5.0. 20 mL of the obtained slurry for polishing was added in a glass test tube having a diameter of 18 mm and left at rest for 10 days. As a result, a supernatant layer did not appear, and the dispersibility was remarkably excellent.

EXAMPLE 3

A white powder was obtained in the same manner as in Example 2 except that the crystallization treatment was carried out by heating at 780°C for 8 hours. The crystallite size of the obtained white powder was 46 nm, the average primary particle size was 87 nm, and the crystallite size:the average primary particle size was 1:1.9.

Except for using the above obtained $CeO_2$ fine particles, dispersion C having an average dispersive particle size of 77 nm and a $CeO_2$ concentration of 1 mass% was obtained in the same manner as in Example 2. To the dispersion C, ammonium polyacrylate and a pH adjuster were added in the same manner as in Example 1 to prepare a slurry for polishing having an ammonium polyacrylate concentration of 0.17 mass% and a pH of 5.0. 20 mL of the obtained slurry for polishing was added in a glass test tube having a diameter of 18 mm and left at rest for 10 days. As a result, a supernatant layer did not appear, and the dispersibility was remarkably excellent.

EXAMPLE 4 (Comparative Example)

A white powder was obtained in the same manner as in Example 2 except that the crystallization treatment was carried out by heating at 900°C for 8 hours. The crystallite size of the obtained white powder was 79 nm, the average primary particle size was 1,370 nm, and the crystallite size:the average primary particle size was 1:17.3.

Except for using the above obtained $CeO_2$ fine particles, dispersion D having an average dispersive particle size of 298 nm and a $CeO_2$ concentration of 1 mass% was obtained in the same manner as in Example 2. To the dispersion D, ammonium polyacrylate and a pH adjuster were added in the same manner as in Example 1 to prepare a slurry for polishing having an ammonium polyacrylate concentration of 0.17 mass% and a pH of 5.0. 20 mL of the obtained slurry for polishing was added in a glass test tube having a diameter of 18 mm and left at rest for 10 days. As a result, a supernatant layer did not appear, and the dispersibility was remarkably excellent.

EXAMPLE 5

900 g of the $CeO_2$ fine particles obtained in Example 1,225 g of deionized water and 9 g of ammonium polyacrylate were added in a container with a cover and mixed, followed by carrying out disperse treatment by a ball milling using zirconia balls having a diameter of 0.5 mm for 72 hours to obtain dispersion E having a $CeO_2$ concentration of 80

mass%. 20 mL of the obtained slurry for polishing was added in a glass test tube having a diameter of 18 mm, and it was observed by visual observation that immediately after the preparation, a solid component precipitated.

(2) CMP TEST

Then, CMP tests were carried out with the slurries obtained in Examples 1 to 4. The CMP tests were carried out by using the following apparatus under the following conditions.

Polishing machine: full automatic CMP machine MIRRA (manufactured, by Applied Materials, Inc.)

Polishing pressure: 20 kPa
Rotational speed: platen 105 rpm,
Head (base holding part) 98 rpm
Rate of feeding the slurry for polishing: 200 mL/minute
Polishing pad: IC1400 (manufactured by Rodel, Inc.)
Object to be polished: 8 inch wafer wherein a film of $SiO_2$ having a thickness of 1,000 nm is formed by plasma CVD on a substrate
Polishing rate: 70 to 80 Å/minute

(3) EVALUATION OF SCRATCH PROPERTIES

A wafer polished under the above polishing condition for 60 seconds was washed and dried, and then the total number of defects larger than 0.2 $\mu$m was counted by using Wafer inspection system 2132, manufactured by KLA-Tencor Corporation. Fig. 1 shows the number of detected defects on the wafers after polishing.

TABLE 1

|  | Number of detected defects |
| --- | --- |
| Example 1 | 260 |
| Example 2 | 390 |
| Example 3 | 1,300 |
| Example 4 | 27,000 |

From the results shown in Table 1, it is evident that in a case where CMP is carried out with the slurry for polishing containing the fine particles of the oxide single crystal such as Examples 1 to 3, it is possible to highly effectively suppress scratches as compared to the case of using the slurry for polishing containing the fine particles of the oxide polycrystal such as Example 4, and therefore, by the present invention, it is possible to obtain a slurry for polishing particularly suitable for accurate polishing in the semiconductor devices production processes.

INDUSTRIAL APPLICABILITY

By using the slurry for polishing containing the fine particles of oxide crystal of the present invention for CMP, polishing properties at a time of polishing are excellent, and scratches on a surface to be polished can be effectively suppressed. Further, it can be preferably used for accurate polishing in a step of polishing glass substrates.

Further, the fine particles of oxide crystal of the present invention are effective as an UV absorber for UV absorbing glass or UV films, gas sensor or electrode materials for solid oxide fuel cells, and abrasive grains for blast media.

The entire disclosure of Japanese Patent Application No. 2006-123828 filed on April 27, 2006 including specification, claims, drawings and summary is incorporated herein by reference in its entirety.

**Claims**

1.    Fine particles of oxide crystal, **characterized in that** the ratio of the crystallite size measured by X-ray diffraction method and calculated by Scherrer method to the average primary particle size equivalent to sphere from the specific surface area measured by BET is the crystallite size:the average primary particle size = 1:0.8 to 1:2.5.

2.    The fine particles of oxide crystal according to Claim 1, wherein the oxide is at least one selected from the group consisting of ceria, titania, tin oxide, zinc oxide, alumina, manganese oxide, zirconia, germanium oxide and solid solutions thereof.

3. The fine particles of oxide crystal according to Claim 1 or 2, wherein the oxide is ceria.

4. The fine particles of oxide crystal according to any one of Claims 1 to 3, wherein the average primary particle size of the fine particles of oxide crystal is from 5 to 200 nm.

5. The fine particles of oxide crystal according to any one of Claims 1 to 4, wherein the porosity of the fine particles of oxide crystal represented by the following formula 1 is from 0.1 to 8%:

$$\text{Porosity} = (1-\text{true density/theoretical density}) \times 100$$

$$\text{Formula 1,}$$

wherein the true density ($g/cm^3$) is a value measured by a dry type densimeter, and the theoretical density ($g/cm^3$) is a value described in JCPDS card number: 34-0394.

6. A method which comprises producing the fine particles of oxide crystal as defined in any one of Claims 1 to 5 by a flux method, a hydrothermal method, a solid phase reaction method, a sol-gel method or a gas phase method.

7. A slurry for polishing, **characterized in that** the fine particles of oxide crystal as defined in any one of Claims 1 to 5 are dispersed in a liquid medium, and from 0.1 to 40 mass% of the fine particles of oxide crystal are contained, per the total mass of the slurry for polishing.

8. The slurry for polishing according to Claim 7, wherein the liquid medium is water or an aqueous medium containing water as the main component.

9. The slurry for polishing according to Claim 7 or 8, wherein the average dispersive particle size of the fine particles of oxide crystal is from 10 to 300 nm.

Fig. 1

50nm

<table>
<tr><td colspan="2">**INTERNATIONAL SEARCH REPORT**</td><td>International application No.<br>PCT/JP2007/059125</td></tr>
</table>

| A. CLASSIFICATION OF SUBJECT MATTER |
|---|
| *C01F17/00*(2006.01)i, *B24B37/00*(2006.01)i, *C09K3/14*(2006.01)i, *H01L21/304* (2006.01)i |
| According to International Patent Classification (IPC) or to both national classification and IPC |

| B. FIELDS SEARCHED |
|---|
| Minimum documentation searched (classification system followed by classification symbols)<br>C01F17/00, B24B37/00, C09K3/14, H01L21/304 |
| Documentation searched other than minimum documentation to the extent that such documents are included in the fields searched<br>Jitsuyo Shinan Koho      1922-1996    Jitsuyo Shinan Toroku Koho   1996-2007<br>Kokai Jitsuyo Shinan Koho   1971-2007   Toroku Jitsuyo Shinan Koho   1994-2007 |
| Electronic data base consulted during the international search (name of data base and, where practicable, search terms used)<br>WPI, CAS ONLINE(STN), JSTPlus(JDream2), Science Direct |

C. DOCUMENTS CONSIDERED TO BE RELEVANT

| Category* | Citation of document, with indication, where appropriate, of the relevant passages | Relevant to claim No. |
|---|---|---|
| X<br>Y | JP 2003-206475 A (Hitachi Maxell, Ltd.),<br>22 July, 2003 (22.07.03),<br>Claims; examples; Figs. 1 to 17<br>& US 2004/0244675 A1    & WO 2003/014251 A1 | 1-4,6-9<br>5 |
| Y | WO 2000/073211 A1 (Hitachi Chemical Co., Ltd.),<br>07 December, 2000 (07.12.00),<br>Claims; page 14, lines 2 to 3; examples<br>& JP 2005-246603 A     & US 6615499 B1<br>& EP 1201607 A1 | 5 |
| A | JP 63-239109 A (Rhone-Poulenc Chimie),<br>05 October, 1988 (05.10.88),<br>& US 4859432 A        & EP 275733 A1 | 1-9 |

| ☒   Further documents are listed in the continuation of Box C. | ☐   See patent family annex. |
|---|---|

| *   Special categories of cited documents: | "T"   later document published after the international filing date or priority date and not in conflict with the application but cited to understand the principle or theory underlying the invention |
|---|---|
| "A"   document defining the general state of the art which is not considered to be of particular relevance | |
| "E"   earlier application or patent but published on or after the international filing date | "X"   document of particular relevance; the claimed invention cannot be considered novel or cannot be considered to involve an inventive step when the document is taken alone |
| "L"   document which may throw doubts on priority claim(s) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O"   document referring to an oral disclosure, use, exhibition or other means | |
| "P"   document published prior to the international filing date but later than the priority date claimed | "&"   document member of the same patent family |

| Date of the actual completion of the international search<br>30 May, 2007 (30.05.07) | Date of mailing of the international search report<br>12 June, 2007 (12.06.07) |
|---|---|
| Name and mailing address of the ISA/<br>    Japanese Patent Office | Authorized officer |
| Facsimile No. | Telephone No. |

Form PCT/ISA/210 (second sheet) (April 2005)

**INTERNATIONAL SEARCH REPORT**

| International application No. |
|---|
| PCT/JP2007/059125 |

C (Continuation). DOCUMENTS CONSIDERED TO BE RELEVANT

| Category* | Citation of document, with indication, where appropriate, of the relevant passages | Relevant to claim No. |
|---|---|---|
| A | JP 6-72711 A (Rhone-Poulenc Speclalites Chimiques), 15 March, 1994 (15.03.94), & US 4663137 A & EP 153227 A1 | 1-9 |
| A | JP 6-340418 A (Rhone-Poulenc Chimie), 13 December, 1994 (13.12.94), & US 6093223 A & EP 599717 A1 | 1-9 |
| A | JP 2004-55861 A (Asahi Glass Co., Ltd.), 19 February, 2004 (19.02.04), (Family: none) | 1-9 |
| A | WO 1999/031195 A1 (Hitachi Chemical Co., Ltd.), 24 June, 1999 (24.06.99), & US 2002/0090895 A1 & EP 1043379 A1 | 1-9 |
| A | WO 2004/104134 A1 (HANWHA CHEMICAL CORP.), 02 December, 2004 (02.12.04), & JP 2007-503521 A | 1-9 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004055861 A
- JP 3727241 B

- JP 2006123828 A

**Non-patent literature cited in the description**

- Detailed Explanation, Semiconductor CMP Techniques. Kogyo Chosakai Publishing, Inc, 2000, 321